(19) Europäisches Patentamt

European Patent Office

Office européen des brevets

(11) **EP 4 723 485 A1**

(12) **EUROPEAN PATENT APPLICATION**
published in accordance with Art. 153(4) EPC

(43) Date of publication:
**08.04.2026 Bulletin 2026/15**

(21) Application number: **23944737.8**

(22) Date of filing: **13.07.2023**

(51) International Patent Classification (IPC):
*H03M 7/30* (2006.01)

(52) Cooperative Patent Classification (CPC):
**H03M 7/30**

(86) International application number:
**PCT/CN2023/107238**

(87) International publication number:
**WO 2025/010719 (16.01.2025 Gazette 2025/03)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• **LI, Jiahui**
  **Shenzhen, Guangdong 518129 (CN)**
• **MA, Mengyao**
  **Shenzhen, Guangdong 518129 (CN)**
• **DU, Yinggang**
  **Shenzhen, Guangdong 518129 (CN)**

(74) Representative: **Pfenning, Meinig & Partner mbB
Patent- und Rechtsanwälte
Theresienhöhe 11a
80339 München (DE)**

(54) **DICTIONARY-BASED DATA COMPRESSION METHOD AND RELATED DEVICE**

(57) Embodiments of this application disclose a dictionary-based data compression method and a related device. The method includes: A first communication device preprocesses first initial data to obtain one or more first eigenvectors. The first communication device obtains compression data of each first eigenvector, where the compression data is obtained based on historical compression information and a first dictionary index that is obtained by compressing the first eigenvector, the historical compression information includes a second dictionary index and a dictionary compression coefficient that are obtained by compressing a second eigenvector, and a dictionary for compressing the second eigenvector is the same as that for compressing the first eigenvector.

FIG. 2

## Description

## TECHNICAL FIELD

Embodiments of this application relate to the computer field, and in particular, to a dictionary-based data compression method and a related device.

## BACKGROUND

Sensing, imaging, artificial intelligence (artificial intelligence, AI)/machine learning (machine learning, ML) computing, and the like at a physical layer are potential technologies and new application scenarios for future communication systems such as cellular communication systems and Wi-Fi communication systems. Future devices such as mobile terminals, sensors, and base stations have capabilities of performing environment sensing and imaging by using electromagnetic signals, to perform offline or real-time modeling and analysis on wireless transmission environment, and finally significantly improve performance of the communication systems. Because a single device has a limited computing capability and battery capacity and an environment range that can be sensed by the device is also limited, sensing results, imaging results, or AI or ML computing results need to be sent to a remote central node (a base station, a server, a cloud computing center, a terminal device with strong computing power, or the like) in a backhaul manner for information convergence. Applications such as sensing, imaging, and integrated sensing and communication involve collection of electromagnetic signals at a plurality of broadband frequencies, in larger-scale antenna arrays, and in different directions. Therefore, a large amount of signal data is obtained, and a compression operation needs to be performed before wireless backhaul, to reduce consumption of wireless transmission resources. For AI/ML applications, processes such as model distribution and online training also involve sending of a large amount of data, and compression processing needs to be performed before transmission.

To improve compression efficiency, technologies such as discrete cosine transform (DCT), discrete Fourier transform (DFT), discrete wavelet transform (DWT), entropy coding, and dictionary-based compression may be introduced. However, efficiency of the dictionary-based compression technology in conventional technologies is unsatisfactory, and a large quantity of resources are occupied.

## SUMMARY

This application provides a dictionary-based data compression method and a related device, to improve data compression efficiency and reduce compression complexity.

This application provides a dictionary-based data compression method.

A first communication device preprocesses first initial data to obtain one or more first eigenvectors. The first communication device obtains compression data of each first eigenvector, where the compression data is obtained based on historical compression information and a first dictionary index that is obtained by compressing the first eigenvector, the historical compression information includes a second dictionary index and a dictionary compression coefficient that are obtained by compressing a second eigenvector, and a dictionary for compressing the second eigenvector is the same as that for compressing the first eigenvector. The compression data includes index information, first coefficient information, and index change information of each first dictionary index, where the index change information indicates whether the first dictionary index is the same as the second dictionary index, the first coefficient information is a dictionary compression coefficient corresponding to the first dictionary index different from the second dictionary index, and the index information includes the first dictionary index different from the second dictionary index.

In this application, compared with carrying all first dictionary indexes and dictionary compression coefficients, the compression data includes only the first dictionary index different from the second dictionary index and the dictionary compression coefficient corresponding to the first dictionary index different from the second dictionary index. Because the dictionary for compressing the first eigenvector is the same as that for compressing the second eigenvector, a first dictionary index that is the same as the second dictionary index can be reconstructed based on the second dictionary index and the index change information. The index information records the first dictionary index different from the second dictionary index. Therefore, all first dictionary indexes can be reconstructed. In addition, if the first dictionary index is the same as the second dictionary index, the dictionary compression coefficient corresponding to the first dictionary index may be considered as equivalent to the dictionary compression coefficient corresponding to the second dictionary index. In conclusion, a part of data in the historical compression information can be reused based on an indication of the index change information, so that compression efficiency can be improved, compression complexity can be reduced, and resource occupation can be reduced.

In a possible implementation, the compression data further includes second coefficient information, the second coefficient information is a differential value between the dictionary compression coefficient corresponding to the first dictionary index and the dictionary compression coefficient corresponding to the second dictionary index, and the first dictionary index is the same as the second dictionary index.

In this application, the dictionary compression coefficient corresponding to the first dictionary index can be restored based on the second coefficient information and the dictionary compression coefficient corresponding to the second dictionary index. Because the differential value occupies less bits than the dictionary compression coefficient, compression efficiency can be improved, compression complexity can be reduced, and resource occupation can be reduced.

In a possible implementation, the second eigenvector is obtained by preprocessing second initial data by the first communication device, the first initial data is data at a first time point, the second initial data is data at a second time point, and the first time point is later than the second time point. The first communication device further sends compression data of the one or more first eigenvectors to a second communication device.

In a possible implementation, the first communication device obtains a target bit matrix, where the target bit matrix is obtained by horizontally concatenating one or more first matrices, the one or more first matrices are respectively obtained based on the compression data of the one or more first eigenvectors, and each of the first matrices sequentially includes a bit layer of index information and a low-order bit layer of first coefficient information in compression data of one first eigenvector from top to bottom. Firstly, the first communication device sends the index change information, the second coefficient information, and a high-order bit layer of the first coefficient information in the compression data of each first eigenvector to the second communication device. Then, the first communication device sequentially sends data in rows from top to bottom in the target bit matrix to the second communication device.

In this application, the target bit matrix is constructed and the data is sent in a specific order, to ensure that when transmission resources are insufficient, data with high importance is preferentially sent, and data with low importance is sent as much as possible.

In a possible implementation, the first communication device obtains a target bit matrix, where the target bit matrix is obtained by horizontally concatenating one or more first matrices, the one or more first matrices are respectively obtained based on the compression data of the one or more first eigenvectors, and each of the first matrices sequentially includes a bit layer of index information and a bit layer of first coefficient information in compression data of one first eigenvector from top to bottom. Firstly, the first communication device sends the index change information in the compression data of each first eigenvector to the second communication device. Then, the first communication device sequentially sends data in rows from top to bottom in the target bit matrix to the second communication device. Then, the first communication device sends the second coefficient information in the compression data of each first eigenvector to the second communication device.

In this application, the target bit matrix is constructed and the data is sent in a specific order, to ensure that when transmission resources are insufficient, data with high importance is preferentially sent, and data with low importance is sent as much as possible.

In a possible implementation, the first communication device communicates with the second communication device to negotiate an initial parameter configuration, where the initial parameter configuration includes a bit width of the differential value.

In this application, the bit width of the differential value is negotiated, so that the second communication device can reconstruct the data after receiving the compression data, to ensure normal communication.

In a possible implementation, the first communication device determines a target quantity of pieces of index change information that indicates a difference and that is in the compression data of the one or more first eigenvectors. If determining that the target quantity is greater than or equal to a preset value, the first communication device triggers the operation of sending the compression data of the one or more first eigenvectors to the second communication device.

In this application, when the target quantity is greater than or equal to the preset value, it indicates that the first initial data changes significantly in comparison with the second initial data. Therefore, the operation of sending the data is triggered, to avoid a waste of resources.

In a possible implementation, the first communication device obtains, based on the historical compression information and the compression data of the first eigenvector, the first dictionary index and the dictionary compression coefficient that are obtained by compressing the first eigenvector. The first communication device updates the historical compression information to the first dictionary index and the dictionary compression coefficient that are obtained by compressing the first eigenvector. The first communication device obtains compression data of a third eigenvector based on updated historical compression information and a dictionary index that is obtained by compressing the third eigenvector, where the third eigenvector is obtained by preprocessing third initial data by the first communication device, the third initial data is data at a third time point, the third time point is later than the second time point, and a dictionary for compressing the third eigenvector is the same as that for compressing the first eigenvector.

In this application, the historical compression information can be updated, so that the historical compression information can be used for compressing a subsequent eigenvector.

In a possible implementation, the first time point and the second time point are separated by a target time interval, the second time point and the third time point are separated by the target time interval, and the target time interval is determined by the first communication device or a second network device.

In this application, the first communication device or the second network device can determine the target time interval, to support dynamic optimization of the solution.

In a possible implementation, a quantity of first dictionary indexes is the same as a quantity of second dictionary indexes. The first communication device further obtains a third dictionary index and a dictionary compression coefficient corresponding to the third dictionary index that are obtained by compressing the first eigenvector, where the third dictionary index and the first dictionary index are all dictionary indexes that are obtained by compressing the first eigenvector. The first communication device sends the third dictionary index and the dictionary compression coefficient corresponding to the third dictionary index for the third eigenvector to the second communication device.

In this application, if a remaining part of dictionary indexes cannot participate in comparison with the second dictionary index, the part of dictionary indexes and dictionary compression coefficients corresponding to the part of dictionary indexes are directly sent to the second communication device, to ensure data integrity.

A second aspect of this application provides a first communication device, including a processor and a memory. The processor is coupled to the memory. The memory is configured to store a program. The processor is configured to execute the program in the memory, to cause the first communication device to perform the method according to the first aspect.

A third aspect of this application provides a computer-readable storage medium, including a program. When the program is run on a computer, the computer is caused to perform the method according to the first aspect.

A fourth aspect of this application provides a computer program product including instructions. When the computer program product runs on a computer, the computer is caused to perform the method according to the first aspect.

## BRIEF DESCRIPTION OF DRAWINGS

FIG. 1 is a diagram of a system architecture to which this application is applied;
FIG. 2 is a diagram of a dictionary-based data compression method according to this application;
FIG. 3 is a diagram of compressing M-dimensional matrix data at a time point t according to this application;
FIG. 4 is a diagram of selecting Km dictionary components from a dictionary m according to this application;
FIG. 5 is a diagram of compressing M-dimensional matrix data at a time point (t+T) according to this application;
FIG. 6 is a diagram of index change information according to this application;
FIG. 7 is a diagram of compression information according to this application;
FIG. 8 is a diagram of a packet assembly manner of compression information according to this application;
FIG. 9 is another diagram of a packet assembly manner of compression information according to this application;
FIG. 10 is a diagram of a compressed bit stream at a time point (t+T) according to this application;
FIG. 11 is another diagram of a compressed bit stream at a time point (t+T) according to this application;
FIG. 12 is a diagram of negotiating an initial configuration parameter according to this application;
FIG. 13 is a diagram of an initial configuration parameter according to this application;
FIG. 14 is a diagram of a new sequence and indication information according to this application;
FIG. 15 is a diagram of a structure of a first communication device according to this application; and
FIG. 16 is a diagram of another structure of a first communication device according to this application.

## DESCRIPTION OF EMBODIMENTS

The following describes embodiments of this application with reference to the accompanying drawings. It is clear that the described embodiments are merely some rather than all of embodiments of this application. A person of ordinary skill in the art may know that with the development of technologies and emergence of new scenarios, the technical solutions provided in embodiments of this application are also applicable to resolving similar technical problems.

In the specification, claims, and accompanying drawings of this application, the terms such as "first" and "second" are intended to distinguish between similar objects but do not necessarily indicate a specific order or sequence. It should be understood that the data termed in such a way are interchangeable in proper circumstances, so that embodiments described herein can be implemented in other orders than the order illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

Embodiments of this application may be implemented according to any proper communication protocol, including but not limited to cellular communication protocols such as a 4th generation (4th generation, 4G), a 5th generation (5th generation, 5G), and a communication protocol evolved after 5G (for example, a 6th generation (6th generation, 6G)), a wireless local area network communication protocol, for example, institute of electrical and electronics engineers (Institute of Electrical and Electronics Engineers, IEEE) 802.11, and/or any other protocol known or developed in the future.

The technical solutions in embodiments of this application are applied to a communication system that complies with any proper communication protocol, for example, a long term evolution (Long Term Evolution, LTE) system, a frequency division duplex (Frequency Division Duplex, FDD) system, a time division duplex (Time Division Duplex, TDD) system, a 5G system (for example, NR), and a communication system evolved after 5G (for example, a 6G system).

For the purpose of description, the following describes embodiments of this application in a background of a cellular communication system in the 3rd generation partnership project (3rd Generation Partnership Project, 3GPP). However, it should be understood that embodiments of this application are not limited to the communication system, but may be applied to any communication system having a similar problem, for example, a wireless local area network (Wireless Local Area Network, WLAN), a wired communication system, or another communication system developed in the future.

The term "terminal" or "terminal device" used in the present disclosure means any terminal device that can perform wired or wireless communication with a network device or between terminal devices. The terminal device may be sometimes referred to as user equipment or UE. The terminal device may be any type of mobile terminal, fixed terminal, or portable terminal. The terminal device may be various wireless communication devices that have a wireless communication function. With emergence of an Internet of Things (Internet of Things, IoT) technology, more devices that previously have no communication function, for example without limitation to, a home appliance, a transportation tool, a tool device, a service device, and a service facility, start to obtain a wireless communication function by being configured with a wireless communication unit, so as to access a wireless communication network, and accept remote management. Such a device has a wireless communication function because the device is configured with a wireless communication unit, and is therefore classified as a wireless communication device. For example, the terminal device may include a mobile cellular phone, a cordless phone, a mobile terminal (Mobile Terminal, MT), a mobile station, a mobile device, a wireless terminal, a handheld device, a client, a subscription station, a portable subscription station, an Internet node, a communicator, a desktop computer, a laptop computer, a notebook computer, a tablet computer, a personal communication system device, a personal navigation device, a personal digital assistant (Personal Digital Assistant, PDA), a wireless data card, a wireless modem (Modulator demodulator, Modem), a positioning device, a radio broadcast receiver, an e-book device, a game device, an IoT device, a vehicle-mounted device, an aircraft, a virtual reality (Virtual Reality, VR) device, an augmented reality (Augmented Reality, AR) device, a wearable device (for example, a smartwatch), a terminal device in a 5G network or any terminal device in an evolved public land mobile network (Public Land Mobile Network, PLMN), another device that can be used for communication, or any combination thereof. This is not limited in embodiments of this application.

The term "network node" or "network device" used in this application is an entity or a node that may be configured to communicate with the terminal device, for example, may be an access network device. The access network device may be an apparatus that is deployed in a radio access network and that provides a wireless communication function for a mobile terminal, for example, may be a radio access network (Radio Access Network, RAN) network device. The access network device may include various types of base stations. The base station is configured to provide a radio access service for the terminal device. Based on a size of a provided service coverage area, the access network device may include a macro base station providing a macro cell (Macro cell), a micro base station providing a micro cell (Pico cell), a pico base station providing a pico cell, and a femto base station providing a femto cell (Femto cell). In addition, the access network device may further include various forms of satellites, relay stations, access points, remote radio units (Remote Radio Unit, RRU), radio heads (Radio Head, RH), remote radio heads (Remote Radio Head, RRH), transmission reception points (transmitting and receiving point, TRP), transmission points (transmitting point, TP), and the like. In systems using different radio access technologies, the access network device may have different names. For example, the access network device is referred to as an evolved NodeB (evolved NodeB, eNB or eNodeB) in an LTE network, is referred to as a NodeB (NodeB, NB) in a 3G network, and may be referred to as a gNodeB (gNB) or an NR NodeB (NR NB) in a 5G network. In some scenarios, the access network device may include a central unit (Central Unit, CU) and/or a distributed unit (Distributed Unit, DU). The CU and the DU may be deployed in different places. For example, the DU is remotely deployed in a high-traffic area, and the CU is deployed in a central equipment room. Alternatively, the CU and the DU may be deployed in a same equipment room. The CU and the DU may alternatively be different components in a rack. The network device may alternatively be a device that undertakes a base station function in device-to-device (Device-to-Device, D2D) communication, vehicle-to-everything (vehicle-to-everything, V2X) communication, or machine-to-machine (machine-to-machine, M2M) communication, or the like. For ease of description, in subsequent embodiments of this application, the foregoing apparatuses that provide the wireless communication function for the mobile terminal are collectively referred to as a network device. This is not specifically limited in embodiments of this application.

This application provides a dictionary-based data compression method and a related device, to improve data compression efficiency and reduce compression complexity.

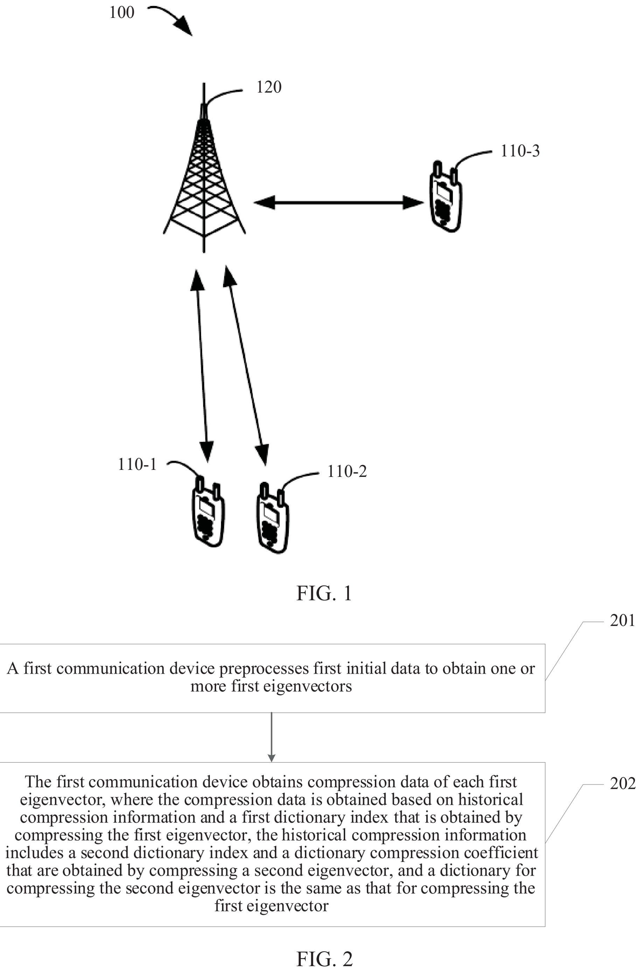

FIG. 1 is a diagram of a communication system 100 in which an embodiment of this application may be implemented. As shown in FIG. 1, the system 100 may include a first terminal device 110-1 to a third terminal device 110-3 (which are collectively referred to as terminal devices 110) and a network device 120. The network device 120 may directly communicate with the terminal device 110. For example, the terminal device 110 may communicate with the corresponding network device 120 over a radio link.

It should be understood that quantities of terminal devices and network devices shown in FIG. 1 are merely used as examples. There may be more or fewer terminal devices and network devices. This is not limited in this application. In this application, a first communication device is the terminal device shown in FIG. 1, and a second communication device is the network device shown in FIG. 1; or the first communication device is the network device shown in FIG. 1, and the second communication device is the terminal device shown in FIG. 1.

Refer to FIG. 2. The following describes a procedure of a dictionary-based data compression method in this application.

201: A first communication device preprocesses first initial data to obtain one or more first eigenvectors.

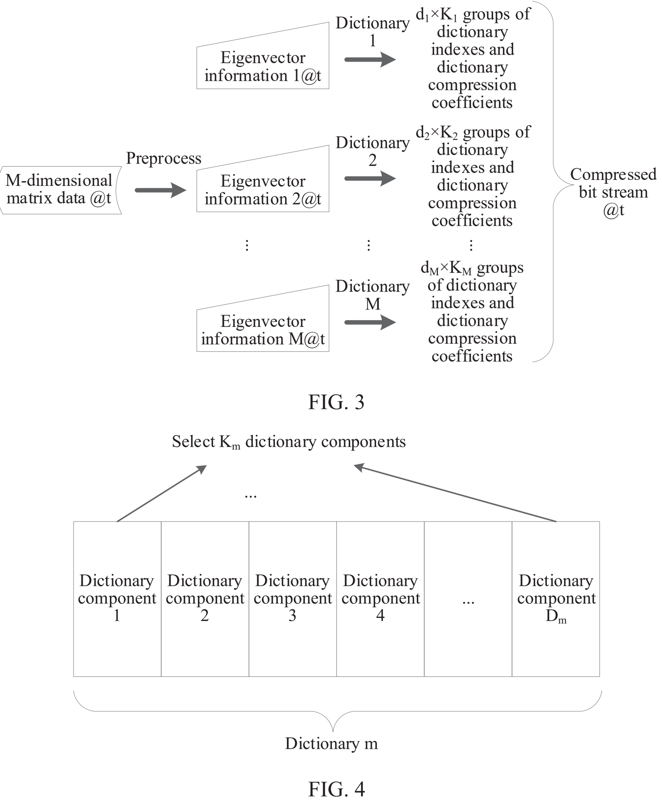

Refer to FIG. 3. The first communication device obtains M-dimensional matrix data @t that needs to be sent (where @t represents that the M-dimensional matrix data is generated at a time point t), and the M-dimensional matrix data is initial data. The first communication device preprocesses the M-dimensional matrix data @t to obtain M corresponding groups of eigenvector information @t (where @t represents that the eigenvector information corresponds to the M-dimensional matrix data generated at the time point t), where eigenvector information m@t includes $d_m$ (where m=1, 2, ..., M) eigenvectors.

202: The first communication device obtains compression data of each first eigenvector, where the compression data is obtained based on historical compression information and a first dictionary index that is obtained by compressing the first eigenvector, the historical compression information includes a second dictionary index and a dictionary compression coefficient that are obtained by compressing a second eigenvector, and a dictionary for compressing the second eigenvector is the same as that for compressing the first eigenvector.

The first communication device separately compresses eigenvectors in the M groups of eigenvector information @t by using M dictionaries. Refer to FIG. 4. The following describes a manner of compressing one eigenvector in the eigenvector information m@t by using a dictionary m.

The dictionary m includes $D_m$ dictionary components in total. The first communication device selects $K_m$ (where m=1, 2, ..., M) dictionary components from the dictionary m, determines a dictionary index of each of the $K_m$ dictionary components in the dictionary m, and determines a dictionary compression coefficient corresponding to each dictionary index, that is, $K_m$ groups of dictionary indexes and dictionary compression coefficients.

Still refer to FIG. 3. Similarly, the first communication device also compresses other eigenvectors in the eigenvector information m@t in the foregoing manner. Therefore, after compressing all the eigenvectors in the eigenvector information m@t, a total of $d_m \times K_m$ groups of dictionary indexes and dictionary compression coefficients are obtained.

The first communication device forms a compressed bit stream @t (where @t represents that the compressed bit stream corresponds to the M-dimensional matrix data generated at the time point t) by using a dictionary index and a dictionary compression coefficient that are obtained by compressing each group of eigenvector information @t, and sends the compressed bit stream @t to a second communication device. The second communication device can reconstruct a corresponding eigenvector based on the dictionary index and the dictionary compression coefficient. The foregoing eigenvector is used as an example. The second communication device determines the $K_m$ dictionary components in the dictionary m based on the $K_m$ dictionary indexes, and approximately represents the eigenvector as $\sum_{k=1}^{K_m} W_{ind_k} X_{ind_k}$. $ind_k$ represents an index of a selected $k^{th}$ (where k=1, 2, ..., $K_m$) dictionary component $X_{ind_k}$ in the dictionary m, and $W_{ind_k}$ represents a dictionary compression coefficient corresponding to the dictionary component. Based on the foregoing manner, the second communication device can reconstruct the M groups of eigenvector information @t, and perform reverse preprocessing on each group of eigenvector information @t to reconstruct the M-dimensional matrix data @t.

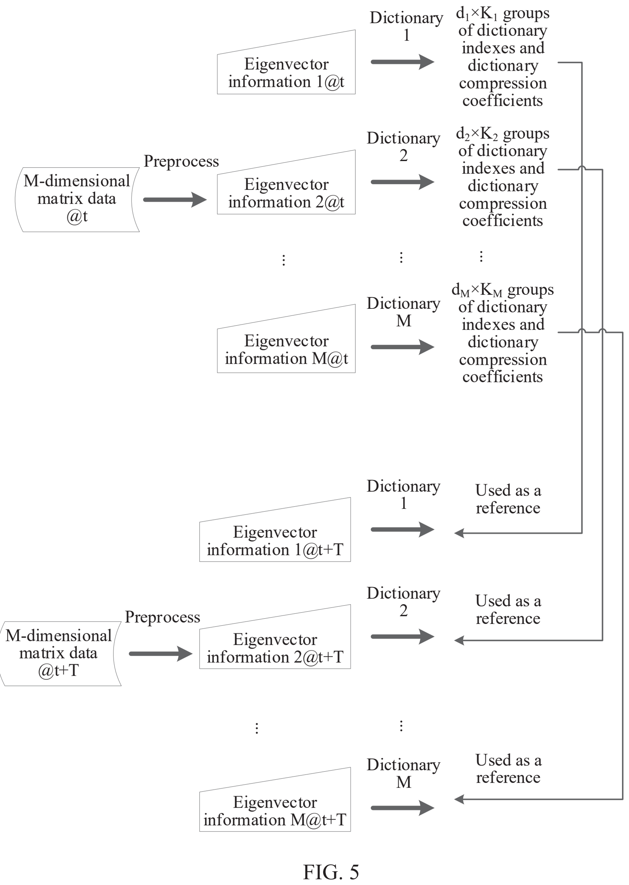

Refer to FIG. 5. After sending the compressed bit stream @t, the first communication device obtains M-dimensional matrix data @t+T (where T may be any time interval, and is denoted as a reference time interval) that needs to be sent, preprocesses the M-dimensional matrix data @t+T to obtain M corresponding groups of eigenvector information @t+T, and similarly, compresses eigenvectors in the M groups of eigenvector information @t+T by using the M dictionaries. When compressing $d_m$ eigenvectors in eigenvector information m@t+T, the first communication device needs to separately make reference to $d_m \times K_m$ groups of dictionary indexes and dictionary components obtained by compressing the eigenvector information m@t. Therefore, the first communication device obtains the dictionary index and the dictionary compression coefficient that are obtained by compressing each group of eigenvector information @t. This part of information is denoted as the historical compression information.

An example in which one eigenvector in the eigenvector information m@t+T is compressed is used. It is assumed that $d_m$ is 1, to specific, the eigenvector information m@t includes one eigenvector. In this case, $1 \times K_m$ groups of dictionary indexes and dictionary compression coefficients are obtained by compressing the eigenvector information m@t. For ease of description, the eigenvector is denoted as an eigenvector a. Similarly, the eigenvector information m@t+T also includes one eigenvector, which is denoted as an eigenvector A. An example in which the eigenvector A is compressed is used. The first communication device first obtains the $K_m$ groups of dictionary indexes and dictionary compression coefficients that are obtained by compressing the eigenvector a. It is assumed that $K_m$ is 2, and the two dictionary indexes are respectively 2 and 3. In addition, to compress the eigenvector A, the first communication device selects two dictionary components from the dictionary m, and dictionary indexes of the two dictionary components are respectively 1 and 3. For ease of subsequent description, a dictionary index that is obtained by compressing the eigenvector A is denoted as a first dictionary index, and a dictionary index that is obtained by compressing the eigenvector a is denoted as a second dictionary index.

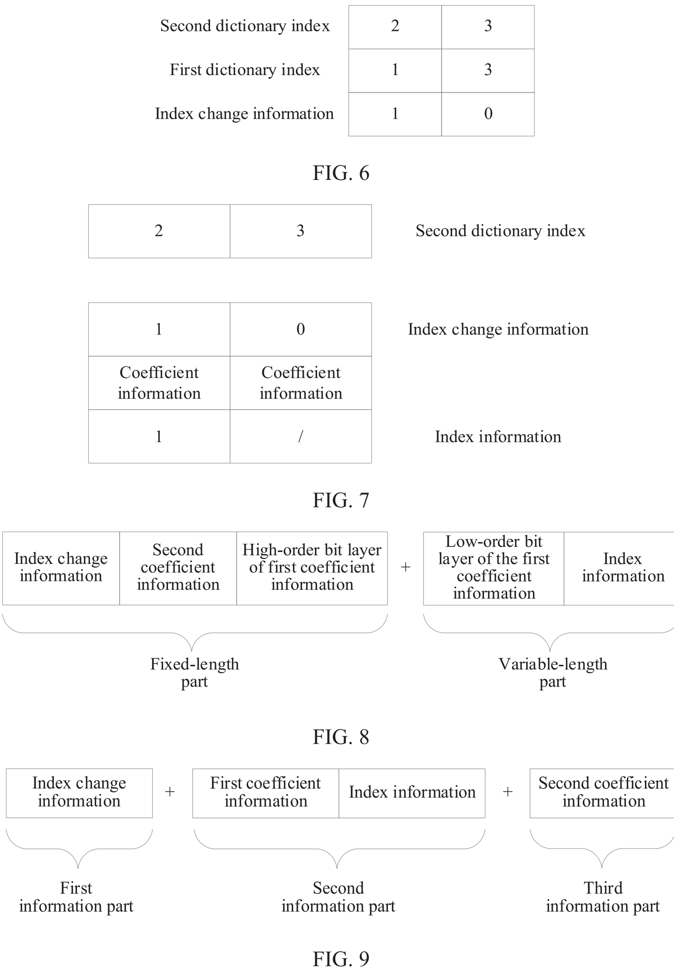

Refer to FIG. 6. The first communication device first compares the first dictionary indexes 1 and 3 with the second dictionary indexes 2 and 3 one by one in sequence, to obtain index change information of each first dictionary index. The index change information indicates whether the first dictionary index changes in comparison with the second dictionary index. In a possible implementation, a form of the index change information may be 0 or 1. When the first dictionary index is the same as the second dictionary index, the index change information is 0. When the first dictionary index is different from the second dictionary index, the index change information is 1. Therefore, after 1 and 3 are compared with 2 and 3, it may be obtained that the index change information is respectively 1 and 0. The first communication device determines, based on the index change information of the first dictionary index, coefficient information corresponding to the first dictionary index. When the index change information is 1, the coefficient information is a dictionary compression coefficient corresponding to the first dictionary index, and is denoted as first coefficient information. The first coefficient information may be represented by using a floating-point number with $L_{cocff,m}$ (where m=1, 2, ..., M) bits, where $L_{cocff,m}$, may be, for example, 16. In a possible implementation, a 1st bit is a sign bit, a 2nd bit to a 6th bit are exponent bits, and a 7th bit to a 16th bit are decimal bits. For example, 1 10000 0010001000 represents that the sign bit is negative, the exponent bit is 24-15=1, and the decimal significand is $(2^7+2^3)/2^{10}=0.1328125$, that is, $-2^1 \times 1.1328125=2.265625$.

When the index change information is 0, the coefficient information is a differential value between the dictionary compression coefficient corresponding to the first dictionary index and a dictionary compression coefficient corresponding to a corresponding second dictionary index, and is denoted as second coefficient information. The corresponding second dictionary index is a second dictionary index for comparison with the first dictionary index. For example, coefficient information of the first dictionary index 3 is a differential value between a dictionary compression coefficient corresponding to the first dictionary index 3 and a dictionary compression coefficient corresponding to the second dictionary index 3. The coefficient information may be represented by using a floating-point number with $L_{diff,m}$ (where m=1, 2, ..., M) bits, where for example, $L_{diff,m}$ is 4. In a possible implementation, a 1st bit is a sign bit, a 2nd bit and a 3rd bit are exponent bits, and a 4th bit is a decimal bit. The dictionary compression coefficient corresponding to the second dictionary index is denoted as a reference value. An absolute value of the differential value is generally less than an absolute value of the reference value. Relative coding may be performed on the exponent bit. If a value of an exponent bit corresponding to the reference value is 10000, and the corresponding exponent bit is 24-15=1, values of 2-bit exponent bits 00, 01, 10, and 11 on which the relative coding is performed may respectively represent that a difference between the 2-bit exponent bits and the exponent bit 1 of the reference value is 1, 2, 3, and 4, and respectively correspond to actual exponent bits 0, -1, -2, and -3 of the differential value. For example, when a 4-bit value is 0 10 1, it indicates that a sign bit is positive, an exponent bit is -2, and a decimal significand is 1/2=0.5, that is, $2^{-2} \times 1.5=0.375$. Optionally, a threshold parameter $\delta$ may be predefined, and a value of the threshold parameter $\delta$ is 0, 1, 2, 3, .... A transmit end and a receive end pre-agree on a specific value. In this case, values of the actual exponent bits are $-\delta$, $-(\delta+1)$, $-(\delta+2)$, and $-(\delta+3)$. When $\delta$ is greater than 0, the actual exponent bits may represent a smaller differential value range. For example, when $\delta$=1 and the 4-bit value is 0 10 1, it indicates that the sign bit is positive, the exponent bit is -(1+2)=-3, and the decimal significand is 1/2=0.5, that is, $2^{-3} \times 1.5=0.1875$.

In addition, the first communication device further obtains index information. The index information includes the first dictionary index different from the second dictionary index. In the foregoing example, the first dictionary index 3 is the same as the second dictionary index 3, but the first dictionary index 1 is different from the second dictionary index 2. Therefore, the index information includes the first dictionary index 1. A quantity of bits needed by each first dictionary index in the index information is $L_{idx,m}$ (where m=1, 2, ..., M).

Refer to FIG. 7. It is not difficult to learn that, when the second dictionary index is determined, if the index change information is 0, it indicates that the first dictionary index is the same as the second dictionary index, so that a corresponding first dictionary index, for example, the first dictionary index 3, is determined; and if the index change information is 1, a corresponding first dictionary index, for example, the first dictionary index 1, may be found in the index information. In addition, if the index change information of the first dictionary index is 0, the dictionary compression coefficient corresponding to the first dictionary index may be obtained based on the coefficient information corresponding to the first dictionary index and the dictionary compression coefficient corresponding to the corresponding second dictionary index.

The index change information, the index information, and the coefficient information are denoted as compression data of the eigenvector A. In a possible implementation, the coefficient information may include only the first coefficient information but not include the second coefficient information. In this case, if the first dictionary index is the same as the second dictionary index, it may be considered that the dictionary compression coefficient corresponding to the first dictionary index is equal to the dictionary compression coefficient of the second dictionary index, that is, the differential value is 0.

Packet assembly may be performed on the compression data of the eigenvector A in two different manners, which are separately described below.

Packet assembly manner 1

Refer to FIG. 8. In this packet assembly manner, the compression data is divided into two parts: a fixed-length part and a variable-length part. The fixed-length part includes the index change information, the second coefficient information, and a high-order bit layer of the first coefficient information. The variable-length part includes a low-order bit layer of the first coefficient information and the index information, and the low-order bit layer is a bit layer other than the high-order bit layer. For example, the high-order bit layer is the first four bits.

Packet assembly manner 2

Refer to FIG. 9. In this packet assembly manner, the compression data is divided into a first information part, a second information part, and a third information part. The first information part includes only the index change information. The second information part includes the first coefficient information and the index information. The third part includes the second coefficient information.

In the manners described above, the first communication device may obtain compression data of each eigenvector in each group of eigenvector information @t+T, perform packet assembly on the compression data to obtain a compressed bit stream @t+T, and send the compressed bit stream @t+T to the second communication device. In a possible implementation, the first communication device sends the compressed bit stream @t+T to the second communication device only when a quantity of pieces of index change information of 1 in all of the compression data is greater than or equal to a preset value.

The following describes quantities of bits occupied by a fixed-length part and a variable-length part of the compressed bit stream @t+T in the two different packet assembly manners.

Packet assembly manner 1

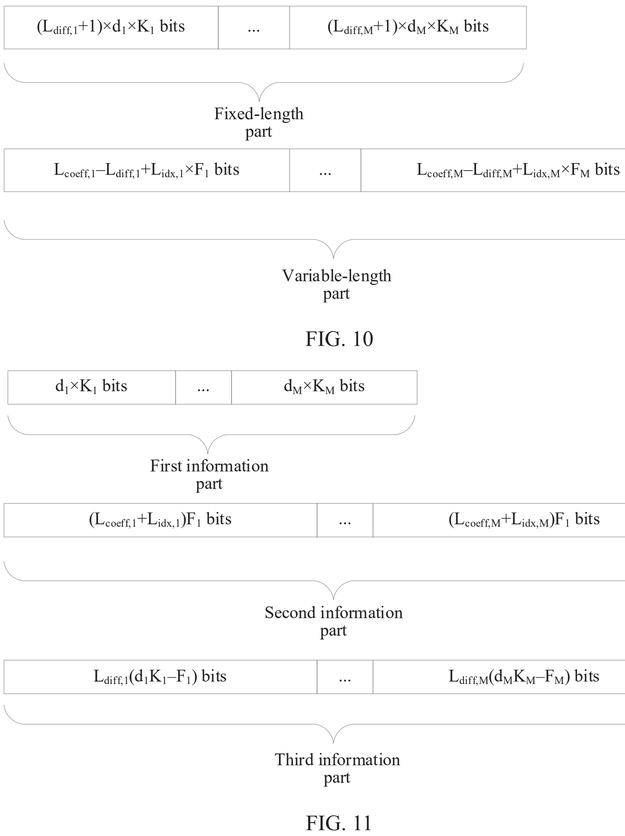

Refer to FIG. 10. It is not difficult to learn that a total quantity of bits occupied by the fixed-length part is

$$\sum_{m=1}^{M}(L_{diff,m}+1)\times d_m\times K_m$$, and a total quantity of bits occupied by the variable-length part is

$$\sum_{m=1}^{M}(L_{coeff,m}-L_{diff,m}+L_{idx,m})\times F_m$$, where $F_m$ is a quantity of pieces of index change information of 1 in all of the compression data obtained by compressing the eigenvector information m@t+T.

Packet assembly manner 2

Refer to FIG. 11. It is not difficult to learn that a total quantity of bits occupied by the first part is

$$\sum_{m=1}^{M}d_m\times K_m$$, a total quantity of bits occupied by the second part is $$\sum_{m=1}^{M}(L_{coeff,m}+L_{idx,m})\times F_m$$, and a total quantity of bits occupied by the third part is

$$\sum_{m=1}^{M}L_{diff,m}\times(d_mK_m-F_m)$$, where $F_m$ is a quantity of pieces of index change information of 1 in all of the compression data obtained by compressing the eigenvector information m@t+T.

It is clear that, in an actual communication scenario, transmission resources allocated by the second communication device to the first communication device are not necessarily sufficient. In this case, it is possible that the first communication device cannot send all of the compressed bit stream @t+T. When the transmission resources are insufficient, the first communication device needs to select data, and perform incremental transmission in a priority order. The following describes in detail manners of sending the compressed bit stream @t+T in the two different packet assembly manners.

Packet assembly manner 1

It is assumed that M is 2, $d_1$ and $d_2$ are both 1, and $K_1$ and $K_2$ are both 2. In this case, information in the compressed bit stream @t+T is, for example, in a form shown in Table 1 below.

Table 1

| 1 | 0 | 0 | 1 | Index change information |
|---|---|---|---|---|
| 0 |   |   | 0 | Index information |
| 0 | / | / | 1 |  |
| 0 |   |   | 0 |  |
| 1 |   |   | 0 |  |
| 0 | 0 | 0 | 1 | Coefficient information |
| 1 | 0 | 0 | 1 |  |
| 0 | 1 | 0 | 1 |  |
| 1 | 0 | 1 | 0 |  |
| 1 |   |   | 1 |  |
| 1 |   |   | 1 |  |
| 1 |   |   | 1 |  |
| 0 | / | / | 0 |  |
| 0 |   |   | 0 |  |
| 0 |   |   | 0 |  |
| 0 |   |   | 0 |  |

1st and 2nd columns from the left correspond to compression data of eigenvector information 1@t+T, and 3rd and 4th columns from the left correspond to compression data of eigenvector information 2@t+T. Information in Table 1 from top to bottom is the index change information occupying 1 bit, the dictionary index occupying 4 bits, and the coefficient information occupying 16 bits or 4 bits.

Refer to FIG. 10 again. In this packet assembly manner, the first communication device first sends all of the fixed-length part in the compressed bit stream @t+T. It is assumed that first separately-coded information occupies 4 bits. In this case, remaining data is shown in Table 2 below.

Table 2

| 0 |   |   | 0 | Index information |
|---|---|---|---|---|
| 0 | / | / | 1 |  |
| 0 |   |   | 0 |  |
| 1 |   |   | 0 |  |
| / |   |   | / | Coefficient information |
| 1 | / | / | 1 |  |
| 1 |   |   | 1 |  |
| 1 |   |   | 1 |  |
| 0 |   |   | 0 |  |
| 0 |   |   | 0 |  |
| 0 |   |   | 0 |  |
| 0 |   |   | 0 |  |

The first communication device constructs, according to a current arrangement rule, the data shown in Table 2 into one target bit matrix, and sequentially sends the data in the rows from top to bottom until transmission resources are exhausted.

Packet assembly manner 2

Refer to FIG. 11 again. In this packet assembly manner, the first communication device first sends all of the first information part in the compressed bit stream @t+T, and remaining data is shown in Table 3 below.

Table 3

| 0 |   |   | 0 | Index information |
|---|---|---|---|---|
| 0 | / | / | 1 |  |
| 0 |   |   | 0 |  |
| 1 |   |   | 0 |  |
| 0 | 0 | 0 | 1 | Coefficient information |
| 1 | 0 | 0 | 1 |  |
| 0 | 1 | 0 | 1 |  |
| 1 | 0 | 1 | 0 |  |
| 1 |   |   | 1 |  |
| 1 |   |   | 1 |  |
| 1 |   |   | 1 |  |
| 0 | / | / | 0 |  |
| 0 |   |   | 0 |  |
| 0 |   |   | 0 |  |
| 0 |   |   | 0 |  |

Then, the first communication device constructs, according to a current arrangement rule, the first coefficient information and the index information in the data shown in Table 3 into one target bit matrix. The target bit matrix includes data in a 1st column and data in a 4th column in Table 3. Then, the data in the rows in the target bit matrix is sent sequentially from top to bottom. If all information in the target bit matrix is sent, remaining data is shown in Table 4 below.

Table 4

|   | / | / |   | Index information |
|---|---|---|---|---|
|   | 0 | 0 |   | Coefficient information |
| / | 0 | 0 | / |  |
|   | 1 | 0 |   |  |
|   | 0 | 1 |   |  |
|   | / | / |   |  |

Then, the first communication device sends all second coefficient information until the transmission resources are exhausted.

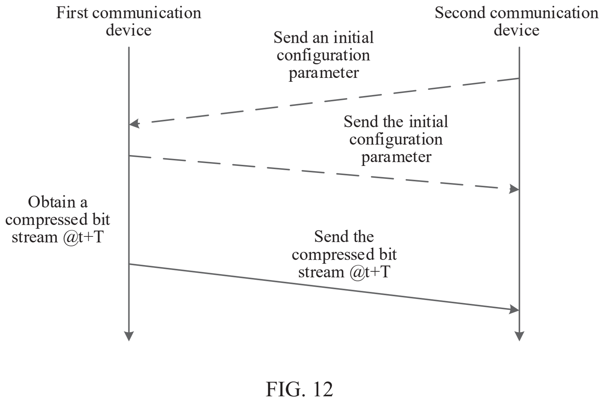

In a possible implementation, refer to FIG. 12. The first communication device further negotiates an initial parameter configuration with the second communication device. The initial parameter configuration may be sent by the first communication device to the second communication device, or may be sent by the second communication device to the first communication device. After the negotiation for the initial parameter configuration is completed, the first communication device obtains the compressed bit stream @t+T in the foregoing manner, and then sends the compressed bit stream @t+T.

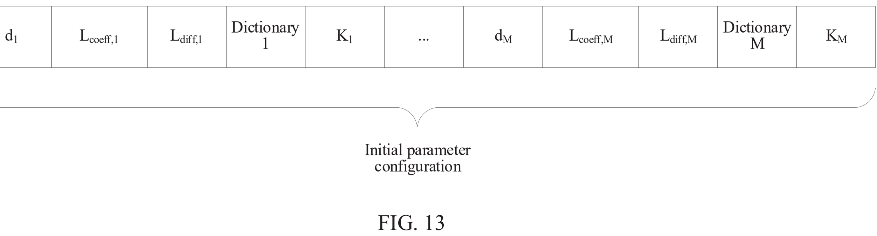

In a possible implementation, refer to FIG. 13. The initial parameter configuration includes $d_1$, $d_2$, ..., $d_M$, $L_{diff,1}$, $L_{diff,2}$, ..., $L_{diff,M}$, $L_{coeff,1}$, $L_{coeff,2}$, ..., $L_{coeff,M}$, $K_1$, $K_2$, ..., $K_M$, a dictionary 1, a dictionary 2, ..., and a dictionary M. The dictionary may be a dictionary or information indicating the dictionary. When the dictionary m is determined, $L_{idx,m}$ may be directly determined. It is clear that the initial parameter configuration may be carried in one piece of signaling for sending, or may be carried in different pieces of signaling for sending, or a part of the initial parameter configuration may be sent by the first communication device to the second communication device, and the other part of the initial parameter configuration may be sent by the second communication device to the first communication device.

Both the first communication device and the second communication device can reconstruct the compressed bit stream @t+T into target compression information with reference to the historical compression information. The target compression information includes a dictionary index and a dictionary compression coefficient that are obtained by compressing each eigenvector in each group of eigenvector information @t+T, and the historical compression information is updated to this part of information. In addition, the second communication device further reconstructs the target compression information into the M groups of eigenvector information @t+T, and further reconstructs the M groups of eigenvector information @t+T into the M-dimensional matrix data @t+T.

Then, the first communication device obtains M-dimensional matrix data @t+2T that needs to be sent, preprocesses the M-dimensional matrix data @t+2T to obtain M corresponding groups of eigenvector information @t+2T, and similarly, compresses eigenvectors in the M groups of eigenvector information @t+2T by using the M dictionaries. When compressing eigenvector information m@t+2T, the first communication device needs to make reference to $d_m \times K_m$ groups of dictionary indexes and dictionary components that correspond to the eigenvector information m@t+T. Therefore, the first communication device obtains updated historical compression information, and compresses each group of eigenvector information @t+2T by using the updated historical compression information as a reference, to obtain a compressed bit stream @t+2T. A specific manner is similar to that described above, and details are not described herein again. It should be understood that only one update of the historical compression information is described above, and the historical compression information may be continuously updated. A subsequent update manner is similar to that described above, and details are not described herein again.

It is clear that T (the reference time interval) mentioned above may be configured by using signaling, and may change dynamically. Buffers reserved by the first communication device and the second communication device for the historical compression information also change with T. For example, if T is updated to T' at a time point i, and T>T', the buffers reserved by the first communication device and the second communication device for the historical compression information are reduced, only historical compression information in a time range from i-T to i-1 is stored, and the data is immediately processed based on the updated time interval T. If T<T', the buffers reserved by the first communication device and the second communication device for the historical compression information increase, and the data is processed at a time point (i+T'-T) based on the updated time interval T.

Alternatively, in a possible implementation, the first communication device and the second communication device pre-negotiate a maximum time interval $T_{max}$. The first communication device separately obtains, at a time point (t+T), historical compression information corresponding to a time point (t+T-1), a time point (t+T-2), a time point (t+T-3), ..., a time point (t+T-T), ..., and a time point (t+T-$T_{max}$), and separately compresses the M-dimensional data @t+T in the foregoing described manner by using the historical compression information as a reference, to determine evaluation information corresponding to each piece of historical compression information. The evaluation information includes a first indicator and a second indicator. The first indicator is a quantity of pieces of index change information of 0 in the compressed bit stream @t+T obtained by compressing the M-dimensional data @t+T by using the historical compression information as a reference. The second indicator is a difference between the target compression information and an actual dictionary index and an actual dictionary compression coefficient that are obtained by compressing each eigenvector in each group of eigenvector information @t+T. The first communication device determines a time point, for example, the time point (t+T-T), corresponding to historical compression information with a minimum first indicator and a minimum second indicator in the evaluation information. The first communication device determines a time interval, that is, T, between the time point (t+T-T) and the time point (t+T) as the reference time interval. It is clear that the first communication device or the second communication device may alternatively determine the reference time interval in another manner. Details are not listed herein.

In the foregoing embodiment, descriptions are provided based on that $K_1$, $K_2$, ..., and $K_M$ do not change. However, in a special case, $K_1$, $K_2$, ..., and $K_M$ may change with a communication scenario. For example, compression precision is improved by increasing $K_m$, or a length of a compressed bit stream is shortened by decreasing $K_m$, to reduce resource consumption. The following describes cases.

Case 1: $K_m$ increases.

An example in which the first communication device compresses the eigenvector information m@t+T is still used for description. A difference lies in that in this embodiment, $K_m$ at a time point t is 2, and $K_m$ at the time point (t+T) is 3. The first communication device first obtains two groups of dictionary indexes and dictionary compression coefficients that are obtained by compressing the eigenvector a. For example, the two dictionary indexes are respectively 2 and 3. In addition, to compress the eigenvector A, the first communication device selects three dictionary components from the dictionary m, and dictionary indexes of the three dictionary components are respectively 1, 3, and 4. For ease of subsequent description, the dictionary index that is obtained by compressing the eigenvector a is denoted as the second dictionary index.

Because $K_m$ at the time point (t+T) increases in comparison with that at the time point t, the first communication device first selects, from the dictionary indexes 1, 3, and 4, dictionary indexes with a quantity the same as a quantity of second dictionary indexes, that is, two dictionary indexes. A selection manner is to select, as much as possible, dictionary indexes that are the same as the second dictionary indexes, for example, select 1 and 3 instead of 1 and 4 from 1, 3, and 4. The selected dictionary indexes are denoted as first dictionary indexes, and the remaining dictionary index is denoted as a third dictionary index.

Then, the first communication device first compares the first dictionary indexes 1 and 3 with the second dictionary indexes 2 and 3 one by one in sequence, to obtain index change information of each first dictionary index. After 1 and 3 are compared with 2 and 3, it may be obtained that the index change information is respectively 1 and 0. The first communication device determines, based on the index change information of the first dictionary index, coefficient information corresponding to the first dictionary index. When the index change information is 1, the coefficient information is a dictionary compression coefficient corresponding to the first dictionary index. When the index change information is 0, the coefficient information is a differential value between the dictionary compression coefficient corresponding to the first dictionary index and a dictionary compression coefficient corresponding to a corresponding second dictionary index. The corresponding second dictionary index is a second dictionary index for comparison with the first dictionary index. In addition, the first communication device further obtains index information. The index information includes the first dictionary index different from the second dictionary index.

The index change information, the coefficient information, and the index information form a part of the compression data of the eigenvector A, and the other part is all third dictionary indexes and dictionary compression coefficients corresponding to the third dictionary indexes.

Case 2: $K_m$ decreases.

An example in which the first communication device compresses the eigenvector information m@t+T is still used for description. A difference lies in that in this embodiment, $K_m$ at a time point t is 4, and $K_m$ at the time point (t+T) is 2. The first communication device first obtains four groups of dictionary indexes and dictionary compression coefficients that are obtained by compressing the eigenvector a. For example, the four dictionary indexes are respectively 2, 3, 4, and 5. In addition, to compress the eigenvector A, the first communication device selects two dictionary components from the dictionary m, and dictionary indexes of the two dictionary components are respectively 2 and 5. For ease of subsequent description, the dictionary index that is obtained by compressing the eigenvector a is denoted as the second dictionary index, and the dictionary index that is obtained by compressing the eigenvector A is denoted as the first dictionary index.

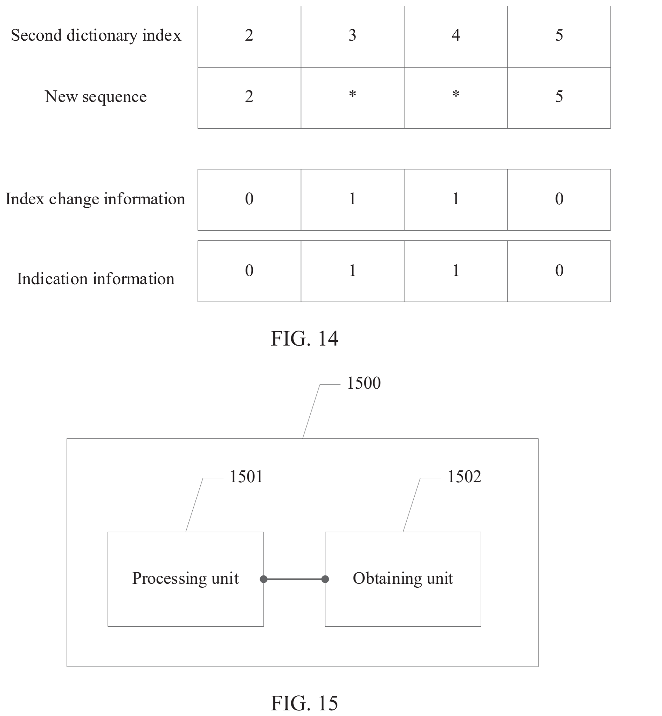

Because $K_m$ at the time point (t+T) decreases by 2 in comparison with that at the time point t, the first communication device obtains two blank dictionary indexes, where the blank dictionary indexes are denoted as *. The first communication device mixes the first dictionary index and the blank dictionary index to obtain a new sequence, for example, 2, *, *, and 5. Refer to FIG. 14. The first communication device compares 2, *, *, and 5 with 2, 3, 4, and 5 one by one in sequence, to obtain that index change information is respectively 0, 1, 1, and 0. In addition, the first communication device further generates indication information. The indication information indicates a location of the blank dictionary index in the new sequence. For example, the indication information is 0, 1, 1, and 0, and the location of the blank dictionary index in the new sequence is marked by using "1".

The first communication device determines, based on the index change information of the first dictionary index, coefficient information corresponding to the first dictionary index. When the index change information is 1, the coefficient information is a dictionary compression coefficient corresponding to the first dictionary index. When the index change information is 0, the coefficient information is a differential value between the dictionary compression coefficient corresponding to the first dictionary index and a dictionary compression coefficient corresponding to a corresponding second dictionary index. The corresponding second dictionary index is a second dictionary index for comparison with the first dictionary index. In addition, the first communication device further obtains index information. The index information includes the first dictionary index different from the second dictionary index. Because the location of the blank dictionary index is clear, the first communication device does not need to perform any operation on the blank dictionary index. The index change information, the coefficient information, the index information, and the indication information are the compression data of the eigenvector A.

In this application, the first eigenvector is compressed with reference the historical compression information, so that compression efficiency is improved, compression complexity is reduced, and resource occupation is reduced.

The foregoing describes the dictionary-based data compression method in this application. The following describes a first network device in this application.

Refer to FIG. 15. A first network device 1500 in this application includes a processing unit 1501 and an obtaining unit 1502.

The processing unit 1501 is configured to preprocess first initial data to obtain one or more first eigenvectors.

The obtaining unit 1502 is configured to obtain compression data of each first eigenvector, where the compression data is obtained based on historical compression information and a first dictionary index that is obtained by compressing the first eigenvector, the historical compression information includes a second dictionary index and a dictionary compression coefficient that are obtained by compressing a second eigenvector, and a dictionary for compressing the second eigenvector is the same as that for compressing the first eigenvector.

The compression data includes index information, first coefficient information, and index change information of each first dictionary index, where the index change information indicates whether the first dictionary index is the same as the second dictionary index, the first coefficient information is a dictionary compression coefficient corresponding to the first dictionary index different from the second dictionary index, and the index information includes the first dictionary index different from the second dictionary index.

In a possible implementation, the compression data further includes second coefficient information, the second coefficient information is a differential value between the dictionary compression coefficient corresponding to the first dictionary index and the dictionary compression coefficient corresponding to the second dictionary index, and the first dictionary index is the same as the second dictionary index.

In a possible implementation, the second eigenvector is obtained by preprocessing second initial data by a first communication device, the first initial data is data at a first time point, the second initial data is data at a second time point, and the first time point is later than the second time point.

The processing unit 1501 is further configured to send compression data of the one or more first eigenvectors to a second communication device.

In a possible implementation, the processing unit 1501 is specifically configured to obtain a target bit matrix, where the target bit matrix is obtained by horizontally concatenating one or more first matrices, the one or more first matrices are respectively obtained based on the compression data of the one or more first eigenvectors, and each of the first matrices sequentially includes a bit layer of index information and a low-order bit layer of first coefficient information in compression data of one first eigenvector from top to bottom.

The processing unit 1501 is specifically configured to send the index change information, the second coefficient information, and a high-order bit layer of the first coefficient information in the compression data of each first eigenvector to the second communication device.

The processing unit 1501 is specifically configured to sequentially send data in rows from top to bottom in the target bit matrix to the second communication device.

In a possible implementation, the processing unit 1501 is specifically configured to obtain a target bit matrix, where the target bit matrix is obtained by horizontally concatenating one or more first matrices, the one or more first matrices are respectively obtained based on the compression data of the one or more first eigenvectors, and each of the first matrices sequentially includes a bit layer of index information and a bit layer of first coefficient information in compression data of one first eigenvector from top to bottom.

The processing unit 1501 is specifically configured to send the index change information in the compression data of each first eigenvector to the second communication device.

The processing unit 1501 is specifically configured to sequentially send data in rows from top to bottom in the target bit matrix to the second communication device.

The processing unit 1501 is specifically configured to send the second coefficient information in the compression data of each first eigenvector to the second communication device.

In a possible implementation, the processing unit 1501 is further configured to communicate with the second communication device to negotiate an initial parameter configuration, where the initial parameter configuration includes a bit width of the differential value.

In a possible implementation, the processing unit 1501 is further configured to determine a target quantity of pieces of index change information that indicates a difference and that is in the compression data of the one or more first eigenvectors.

The processing unit 1501 is specifically configured to: if determining that the target quantity is greater than or equal to a preset value, trigger the operation of sending the compression data of the one or more first eigenvectors to the second communication device.

In a possible implementation, the obtaining unit 1502 is further configured to obtain, based on the historical compression information and the compression data of the first eigenvector, the first dictionary index and the dictionary compression coefficient that are obtained by compressing the first eigenvector.

The processing unit 1501 is further configured to update the historical compression information to the first dictionary index and the dictionary compression coefficient that are obtained by compressing the first eigenvector.

The obtaining unit 1502 is further configured to obtain compression data of a third eigenvector based on updated historical compression information and a dictionary index that is obtained by compressing the third eigenvector, where the third eigenvector is obtained by preprocessing third initial data by the first communication device, the third initial data is data at a third time point, the third time point is later than the second time point, and a dictionary for compressing the third eigenvector is the same as that for compressing the first eigenvector.

In a possible implementation, the first time point and the second time point are separated by a target time interval, the second time point and the third time point are separated by the target time interval, and the target time interval is determined by the first communication device or the third eigenvector.

In a possible implementation, a quantity of first dictionary indexes is the same as a quantity of second dictionary indexes.

The obtaining unit 1502 is further configured to obtain a third dictionary index and a dictionary compression coefficient corresponding to the third dictionary index that are obtained by compressing the first eigenvector, where the first dictionary index and the third dictionary index are all dictionary indexes that are obtained by compressing the first eigenvector.

The processing unit 1501 is further configured to send the third dictionary index and the dictionary compression coefficient of the third dictionary index to the second communication device.

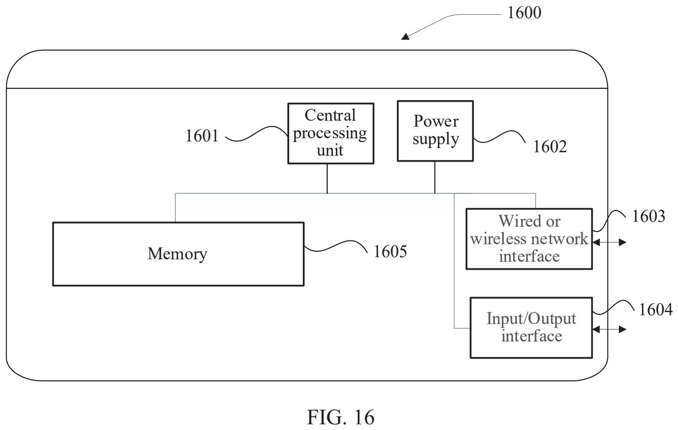

FIG. 16 is a diagram of a structure of a first network device according to this application. The first network device may include one or more central processing units (central processing unit, CPU) 1601 and a memory 1605. The memory 1605 stores one or more application programs or data.

The memory 1605 may be a volatile storage or a persistent storage. The program stored in the memory 1605 may include one or more modules, and each module may include a series of instruction operations on a server. Further, the central processing unit 1601 may be configured to: communicate with the memory 1605, and perform, on the first network device 1600, the series of instruction operations in the memory 1605.

The first network device 1600 may further include one or more power supplies 1602, one or more wired or wireless network interfaces 1603, one or more input/output interfaces 1604, and/or one or more operating systems.

The central processing unit 1601 may perform the foregoing operations of the first network device. Details are not described herein again.

It may be clearly understood by a person skilled in the art that, for convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the apparatus embodiments described above are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in an electronic form, a mechanical form, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to conventional technologies, or all or some of the technical solutions may be implemented in a form of a software product. The computer software product is stored in a storage medium and includes several instructions for instructing a computer device (which may be a personal computer, a server, a network device, or the like) to perform all or some of the steps of the methods described in embodiments of this application. The foregoing storage medium includes any medium that can store program code, such as a USB flash drive, a removable hard disk, a read-only memory (ROM, read-only memory), a random access memory (RAM, random access memory), a magnetic disk, or an optical disc.

**Claims**

1. A dictionary-based data compression method, comprising:

   preprocessing, by a first communication device, first initial data to obtain one or more first eigenvectors; and
   obtaining, by the first communication device, compression data of each first eigenvector, wherein the compression data is obtained based on historical compression information and a first dictionary index that is obtained by compressing the first eigenvector, the historical compression information comprises a second dictionary index and a dictionary compression coefficient that are obtained by compressing a second eigenvector, and a dictionary for compressing the second eigenvector is the same as that for compressing the first eigenvector; and the compression data comprises index information, first coefficient information, and index change information of each first dictionary index, wherein the index change information indicates whether the first dictionary index is the same as the second dictionary index, the first coefficient information is a dictionary compression coefficient corresponding to the first dictionary index different from the second dictionary index, and the index information comprises the first dictionary index different from the second dictionary index.

2. The method according to claim 1, wherein the compression data further comprises second coefficient information, the second coefficient information is a differential value between the dictionary compression coefficient corresponding to the first dictionary index and the dictionary compression coefficient corresponding to the second dictionary index, and the first dictionary index is the same as the second dictionary index.

3. The method according to claim 2, wherein the second eigenvector is obtained by preprocessing second initial data by the first communication device, the first initial data is data at a first time point, the second initial data is data at a second time point, and the first time point is later than the second time point; and the method further comprises:
   sending, by the first communication device, compression data of the one or more first eigenvectors to a second communication device.

4. The method according to claim 3, wherein sending, by the first communication device, the compression data of the one or more first eigenvectors to the second communication device comprises:

   obtaining, by the first communication device, a target bit matrix, wherein the target bit matrix is obtained by horizontally concatenating one or more first matrices, the one or more first matrices are respectively obtained based on the compression data of the one or more first eigenvectors, and each of the first matrices sequentially comprises a bit layer of index information and a low-order bit layer of first coefficient information in compression data of one first eigenvector from top to bottom;
   firstly, sending, by the first communication device, the index change information, the second coefficient information, and a high-order bit layer of the first coefficient information in the compression data of each first eigenvector to the second communication device; and
   then, sequentially sending, by the first communication device, data in rows from top to bottom in the target bit matrix to the second communication device.

5. The method according to claim 3, wherein sending, by the first communication device, the compression data of the one or more first eigenvectors to the second communication device comprises:

   obtaining, by the first communication device, a target bit matrix, wherein the target bit matrix is obtained by horizontally concatenating one or more first matrices, the one or more first matrices are respectively obtained based on the compression data of the one or more first eigenvectors, and each of the first matrices sequentially comprises a bit layer of index information and a bit layer of first coefficient information in compression data of one first eigenvector from top to bottom;
   firstly, sending, by the first communication device, the index change information in the compression data of each first eigenvector to the second communication device;
   then, sequentially sending, by the first communication device, data in rows from top to bottom in the target bit matrix to the second communication device; and
   then, sending, by the first communication device, the second coefficient information in the compression data of each first eigenvector to the second communication device.

6. The method according to any one of claims 2 to 5, wherein the method further comprises:

communicating, by the first communication device, with the second communication device to negotiate an initial parameter configuration, wherein the initial parameter configuration comprises a bit width of the differential value.

7. The method according to claim 6, wherein the method further comprises:

determining, by the first communication device, a target quantity of pieces of index change information that indicates a difference and that is in the compression data of the one or more first eigenvectors; and
sending, by the first communication device, the compression data of the one or more first eigenvectors to the second communication device comprises:
if determining that the target quantity is greater than or equal to a preset value, triggering, by the first communication device, the operation of sending the compression data of the one or more first eigenvectors to the second communication device.

8. The method according to claim 7, wherein the method further comprises:

obtaining, by the first communication device based on the historical compression information and the compression data of the first eigenvector, the first dictionary index and the dictionary compression coefficient that are obtained by compressing the first eigenvector;
updating, by the first communication device, the historical compression information to the first dictionary index and the dictionary compression coefficient that are obtained by compressing the first eigenvector; and
obtaining, by the first communication device, compression data of a third eigenvector based on updated historical compression information and a dictionary index that is obtained by compressing the third eigenvector, wherein the third eigenvector is obtained by preprocessing third initial data by the first communication device, the third initial data is data at a third time point, the third time point is later than the second time point, and a dictionary for compressing the third eigenvector is the same as that for compressing the first eigenvector.

9. The method according to claim 8, wherein the first time point and the second time point are separated by a target time interval, the second time point and the third time point are separated by the target time interval, and the target time interval is determined by the first communication device or the second communication device.

10. The method according to claim 3, wherein a quantity of first dictionary indexes is the same as a quantity of second dictionary indexes; and
the method further comprises:

obtaining, by the first communication device, a third dictionary index and a dictionary compression coefficient corresponding to the third dictionary index that are obtained by compressing the first eigenvector, wherein the first dictionary index and the third dictionary index are all dictionary indexes that are obtained by compressing the first eigenvector; and
sending, by the first communication device, the third dictionary index and the dictionary compression coefficient of the third dictionary index to the second communication device.

11. A first communication device, comprising a processor and a memory, wherein the processor is coupled to the memory, the memory is configured to store a program, and the processor is configured to execute the program in the memory, to cause the first communication device to perform the method according to any one of claims 1 to 10.

12. A computer-readable storage medium, comprising a program, wherein when the program is run on a computer, the computer is caused to perform the method according to any one of claims 1 to 10.

13. A computer program product comprising instructions, wherein when the computer program product runs on a computer, the computer is caused to perform the method according to any one of claims 1 to 10.

100

120

110-3

110-1

110-2

FIG. 1

201

A first communication device preprocesses first initial data to obtain one or more first eigenvectors

202

The first communication device obtains compression data of each first eigenvector, where the compression data is obtained based on historical compression information and a first dictionary index that is obtained by compressing the first eigenvector, the historical compression information includes a second dictionary index and a dictionary compression coefficient that are obtained by compressing a second eigenvector, and a dictionary for compressing the second eigenvector is the same as that for compressing the first eigenvector

FIG. 2

FIG. 3

FIG. 4

Eigenvector information 1@t → Dictionary 1 → $d_1 \times K_1$ groups of dictionary indexes and dictionary compression coefficients

M-dimensional matrix data @t → Preprocess → Eigenvector information 2@t → Dictionary 2 → $d_2 \times K_2$ groups of dictionary indexes and dictionary compression coefficients

⋮ ⋮ ⋮

Eigenvector information M@t → Dictionary M → $d_M \times K_M$ groups of dictionary indexes and dictionary compression coefficients

Eigenvector information 1@t+T → Dictionary 1 → Used as a reference

M-dimensional matrix data @t+T → Preprocess → Eigenvector information 2@t+T → Dictionary 2 → Used as a reference

⋮ ⋮

Eigenvector information M@t+T → Dictionary M → Used as a reference

FIG. 5

| Second dictionary index | 2 | 3 |
|---|---|---|
| First dictionary index | 1 | 3 |
| Index change information | 1 | 0 |

FIG. 6

| 2 | 3 | Second dictionary index |
|---|---|---|

| 1 | 0 | Index change information |
|---|---|---|
| Coefficient information | Coefficient information | |
| 1 | / | Index information |

FIG. 7

| Index change information | Second coefficient information | High-order bit layer of first coefficient information | + | Low-order bit layer of the first coefficient information | Index information |
|---|---|---|---|---|---|

Fixed-length part    Variable-length part

FIG. 8

| Index change information | + | First coefficient information | Index information | + | Second coefficient information |
|---|---|---|---|---|---|

First information part    Second information part    Third information part

FIG. 9

| $(L_{diff,1}+1)\times d_1 \times K_1$ bits | ... | $(L_{diff,M}+1)\times d_M \times K_M$ bits |
|---|---|---|

Fixed-length
part

| $L_{coeff,1}-L_{diff,1}+L_{idx,1}\times F_1$ bits | ... | $L_{coeff,M}-L_{diff,M}+L_{idx,M}\times F_M$ bits |
|---|---|---|

Variable-length
part

FIG. 10

| $d_1 \times K_1$ bits | ... | $d_M \times K_M$ bits |
|---|---|---|

First information
part

| $(L_{coeff,1}+L_{idx,1})F_1$ bits | ... | $(L_{coeff,M}+L_{idx,M})F_1$ bits |
|---|---|---|

Second information
part

| $L_{diff,1}(d_1 K_1 - F_1)$ bits | ... | $L_{diff,M}(d_M K_M - F_M)$ bits |
|---|---|---|

Third information
part

FIG. 11

First communication
device

Second communication
device

Send an initial
configuration
parameter

Send the initial
configuration
parameter

Obtain a
compressed bit
stream @t+T

Send the
compressed bit
stream @t+T

FIG. 12

| $d_1$ | $L_{coeff,1}$ | $L_{diff,1}$ | Dictionary 1 | $K_1$ | ... | $d_M$ | $L_{coeff,M}$ | $L_{diff,M}$ | Dictionary M | $K_M$ |
|---|---|---|---|---|---|---|---|---|---|---|

Initial parameter
configuration

FIG. 13

| Second dictionary index | 2 | 3 | 4 | 5 |
|---|---|---|---|---|
| New sequence | 2 | * | * | 5 |

| Index change information | 0 | 1 | 1 | 0 |
|---|---|---|---|---|
| Indication information | 0 | 1 | 1 | 0 |

FIG. 14

FIG. 15

FIG. 16

## INTERNATIONAL SEARCH REPORT

| International application No. |
|---|
| **PCT/CN2023/107238** |

### A. CLASSIFICATION OF SUBJECT MATTER

H03M 7/30(2006.01)i

According to International Patent Classification (IPC) or to both national classification and IPC

### B. FIELDS SEARCHED

Minimum documentation searched (classification system followed by classification symbols)

IPC: H03M

Documentation searched other than minimum documentation to the extent that such documents are included in the fields searched

Electronic data base consulted during the international search (name of data base and, where practicable, search terms used)

CNABS, CNTXT, ENTXTC, CNKI, ISI, IEEE, Bing, baidu: 字典, 索引, 压缩, 差分, 差异, 差别, 差值, 历史, 前, 过去, 相同, 同一, compress+, dictionary, index+, previous, differen+, same

### C. DOCUMENTS CONSIDERED TO BE RELEVANT

| Category* | Citation of document, with indication, where appropriate, of the relevant passages | Relevant to claim No. |
|---|---|---|
| A | WO 2021000763 A1 (DATANG MOBILE COMMUNICATIONS EQUIPMENT CO., LTD.) 07 January 2021 (2021-01-07) claims 1-27, and description, pages 10-11 | 1-13 |
| A | US 2003222804 A1 (BROADCOM CORP.) 04 December 2003 (2003-12-04) entire document | 1-13 |
| A | US 2013018889 A1 (INTERNATIONAL BUSINESS MACHINES CORP.) 17 January 2013 (2013-01-17) entire document | 1-13 |
| A | US 2014149605 A1 (ANNAMALAISAMI, S. et al.) 29 May 2014 (2014-05-29) entire document | 1-13 |
| A | WO 2022253023 A1 (HUAWEI TECHNOLOGIES CO., LTD.) 08 December 2022 (2022-12-08) entire document | 1-13 |
| A | WO 2023125699 A1 (HUAWEI TECHNOLOGIES CO., LTD.) 06 July 2023 (2023-07-06) entire document | 1-13 |

| ☐ Further documents are listed in the continuation of Box C. | ☑ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **02 January 2024** | **09 January 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/107238**

| Patent document cited in search report | | | Publication date (day/month/year) | Patent family member(s) | | | Publication date (day/month/year) |
|---|---|---|---|---|---|---|---|
| WO | 2021000763 | A1 | 07 January 2021 | None | | | |
| US | 2003222804 | A1 | 04 December 2003 | US | 6720894 | B2 | 13 April 2004 |
| | | | | US | 2004170279 | A1 | 02 September 2004 |
| | | | | US | 7375662 | B2 | 20 May 2008 |
| US | 2013018889 | A1 | 17 January 2013 | US | 8990217 | B2 | 24 March 2015 |
| US | 2014149605 | A1 | 29 May 2014 | HK | 1215109 | A1 | 12 August 2016 |
| | | | | EP | 2923443 | A1 | 30 September 2015 |
| | | | | WO | 2014082016 | A1 | 30 May 2014 |
| WO | 2022253023 | A1 | 08 December 2022 | None | | | |
| WO | 2023125699 | A1 | 06 July 2023 | None | | | |

Form PCT/ISA/210 (patent family annex) (July 2022)